Europäisches Patentamt

European Patent Office

Office européen des brevets

(11) Numéro de publication : **0 406 930 B1**

# (12) FASCICULE DE BREVET EUROPEEN

(45) Date de publication du fascicule du brevet :
01.02.95 Bulletin 95/05

(51) Int. Cl.$^6$ : **G11C 27/02**

(21) Numéro de dépôt : **90201577.5**

(22) Date de dépôt : **18.06.90**

(54) **Circuit de commutation, notamment pour un échantillonneur bloqueur.**

(30) Priorité : **23.06.89 FR 8908418**

(43) Date de publication de la demande :
**09.01.91 Bulletin 91/02**

(45) Mention de la délivrance du brevet :
**01.02.95 Bulletin 95/05**

(84) Etats contractants désignés :
**DE FR GB IT**

(56) Documents cités :
**EP-A- 0 213 845**
**EP-A- 0 263 750**

(73) Titulaire : **PHILIPS COMPOSANTS**
**4, rue du Port aux Vins**
**F-92150 Suresnes (FR)**
(84) **FR**
Titulaire : **Philips Electronics N.V.**
**Groenewoudseweg 1**
**NL-5621 BA Eindhoven (NL)**
(84) **DE GB IT**

(72) Inventeur : **Gloaguen, Gilbert**
**Société Civile S.P.I.D.,**
**209 rue de l'Université**
**F-75007 Paris (FR)**

(74) Mandataire : **Charpail, François et al**
**Société Civile S.P.I.D.**
**156, Boulevard Haussmann**
**F-75008 Paris (FR)**

## Description

La présente invention se rapporte à un circuit de commutation notamment pour un échantillonneur bloqueur comportant un pont de diodes présentant une première branche série comportant une première et une deuxième diode en direct, en parallèle avec une deuxième branche série comportant un troisième et une quatrième diode en direct au moins une première extrémité commune aux deux dites branches série étant connectée à une première source de courant commutable présentant un premier état où elle est couplée à la première extrémité commune et un deuxième état où elle est découplée de la première extrémité commune, la première branche série comportant une borne d'entrée au point commun à la première et à la deuxième diode et agencée pour recevoir une tension d'entrée, la deuxième branche série comportant une borne de sortie au point commun à la troisième et à la quatrième diode. Dans le cas d'un échantillonneur-bloqueur, la borne de sortie à laquelle est connectée à un condensateur de mémorisation, le premier état est un état d'échantillonnage et le deuxième état est un état de blocage.

Ces échantillonneurs bloqueurs connus exigent la commutation simultanée de deux sources de courant, l'une réalisée avec des transistors pnp et l'autre avec des transistors npn. Or, dans les procédés usuels de fabrication de circuits intégrés les transistors pnp sont notablement moins rapides. En outre, la synchronisation parfaite de la commutation de transistors de type différents est difficile à obtenir.

L'antériorité US 3 597 633 décrit un circuit de commutation, notamment pour un échantillonneur-bloqueur, dans laquelle est mise en oeuvre une seule commutation, celle d'un transistor, mais ce circuit ne prévoit pas la commutation de véritables sources de courant. EP-A-0 263 750 divulgue un circuit qui comporte toutes les caractéristiques du préambule de la revendication 1.

La présente invention propose un circuit échantillonneur bloqueur dans lequel la commutation d'une seule source de courant, de préférence réalisée à partir de transistors npn, suffit à réaliser la fonction principale désirée.

Un circuit échantillonneur-bloqueur selon l'invention est défini par les caractéristiques de la revendication 1.

La première source de courant commutable peut comporter un premier étage différentiel agencé pour commuter un courant d'intensité donnée entre lesdites première et deuxième extrémité commune respectivement dans l'état d'échantillonnage et l'état de blocage, en réponse à un signal de commande.

Le circuit selon l'invention peut selon un premier mode de réalisation comporter un circuit générateur de courant agencé pour injecter à ladite deuxième extrémité commune un courant de compensation variant en fonction de la tension d'entrée de manière à rendre l'équilibre du pont indépendant de ladite tension d'entrée.

Le générateur de courant peut être alors un deuxième étage différentiel commutable agencé pour que ledit courant de compensation soit produit à partir d'une troisième source de courant d'intensité donnée. Le deuxième étage différentiel peut présenter un troisième et un quatrième transistor dont les émetteurs sont couplés à travers une deuxième et une troisième résistance en série au point commun desquelles est connectée la troisième source de courant, la base du troisième transistor étant agencée pour recevoir ladite tension d'entrée et son collecteur étant connecté à la source de tension d'alimentation, la base du quatrième transistor étant agencée pour recevoir une tension de référence et son collecteur étant connecté à ladite deuxième extrémité commune. Ce dernier mode de réalisation permet d'obtenir une bonne linéarité de la compensation.

La troisième source de courant peut avoir pour intensité :

$$I' = \frac{V_H - V_B}{R} \text{ avec } R = \frac{2}{I}(V_{cc} - V_{BE} - V_H)$$

$V_H$ : valeur maximale du signal d'entrée $V_e$

$V_B$ : valeur minimale du signal d'entrée $V_e$

$R$ : valeur de la première résistance.

$V_{BE}$ : tension base-émetteur d'un transistor.

$V_{cc}$ : tension d'alimentation.

$I$ : intensité de la première source de courant d'intensité donnée.

On utilise de la sorte tout le courant $I'$ pour réaliser la compensation désirée.

Une linéarisation optimale de la correction est alors obtenue lorsque

$$R_2 = R_3 = \frac{R}{2} - \frac{2kT}{q}\frac{R}{V_H - V_B}\text{Log}3$$

Selon un mode de réalisation préféré, l'équilibre du pont est indépendant de la tension d'entrée et de la tension d'alimentation, et dans ce but, la première source de courant est agencée de manière que son courant $I$ varie selon une loi donnée, à savoir :

EP 0 406 930 B1

$$I = 2\frac{V_{cc} - V_e}{R}$$

Selon une variante avantageuse de ce mode de réalisation, la première source de courant est montée en miroir de courant un rapport k avec une quatrième source de courant dont l'intensité est fonction de la tension d'alimentation, et qui fournit une partie de son courant à une cinquième source de courant dont l'intensité est fonction de la tension d'entrée, de manière que l'intensité de la première source de courant suive la loi précitée.

La quatrième source de courant peut comporter une quatrième résistance dont une première borne est connectée à la source de tension d'alimentation et dont la deuxième borne est connectée à la cinquième source de courant, la quatrième résistance étant agencée de manière que le courant de la quatrième source de courant dépende linéairement de la valeur de la quatrième résistance.

Le rapport K entre les courants des première et quatrième source de courant a préférentiellement pour valeur

$$K = 2\frac{R_4}{R}$$

avec $R_4$ = valeur de la quatrième résistance.

La cinquième source de courant peut comporter un cinquième transistor dont la base est agencée pour être alimentée par ladite tension d'entrée, dont le collecteur est connecté à ladite source de tension d'alimentation et dont l'émetteur comporte en série une cinquième résistance et une septième diode en direct le point commun à la cinquième résistance et à la septième diode étant connecté à la base d'un sixième transistor dont le collecteur est connecté à la deuxième borne de la quatrième résistance pour délivrer le courant désiré.

On obtient ainsi un montage en miroir de courant délivrant un courant fonction de la tension d'entrée.

Les dimensions du sixième transistor et de la septième diode sont de préférence telles qu'ils sont traversés par des courants dans un rapport N et en ce que :

$$N = \frac{R_{10}}{R_4}$$

$R_{10}$ désignant la valeur de la cinquième résistance.

Un deuxième circuit générateur de courant peut être agencé pour injecter un courant transitoire à ladite première extrémité commune lors d'une transition de l'état d'échantillonnage à l'état de blocage, de manière à fournir le courant transitoire à travers le premier étage différentiel.

Le deuxième circuit générateur de courant peut, selon une variante préférée comporter un septième transistor dont le collecteur est connecté à la source de tension d'alimentation, dont l'émetteur est connecté à la première extrémité commune et dont la base est reliée d'une part à la source de tension d'alimentation à travers une huitième diode en série avec une sixième résistance et d'autre part à une borne de sortie d'un troisième circuit de commutation agencé pour le connecter à une sixième source de courant dont l'intensité est proportionnelle à celle de la quatrième source de courant, lors du passage de l'état d'échantillonnage à l'état de blocage. Les deuxième et quatrième diodes sont avantageusement de type Schottky.

L'invention sera mieux comprise à la lecture de la description qui va suivre, donnée à titre d'exemple non limitatif, en liaison avec les dessins qui représentent :
  - la figure 1, un échantillonneur-bloqueur classique selon l'art antérieur.
  - la figure 2, un échantillonneur-bloqueur comprenant un circuit de commutation selon l'invention.
  - la figure 3, une variante selon l'invention, corrigeant l'influence de la valeur de la tension d'entrée sur la tension mémorisée et la figure 4 une version à linéarité améliorée de cette variante,
  - et la figure 5 un mode préféré de réalisation de l'invention présentant des corrections statiques (tension d'entrée et tension d'alimentation) et dynamiques.

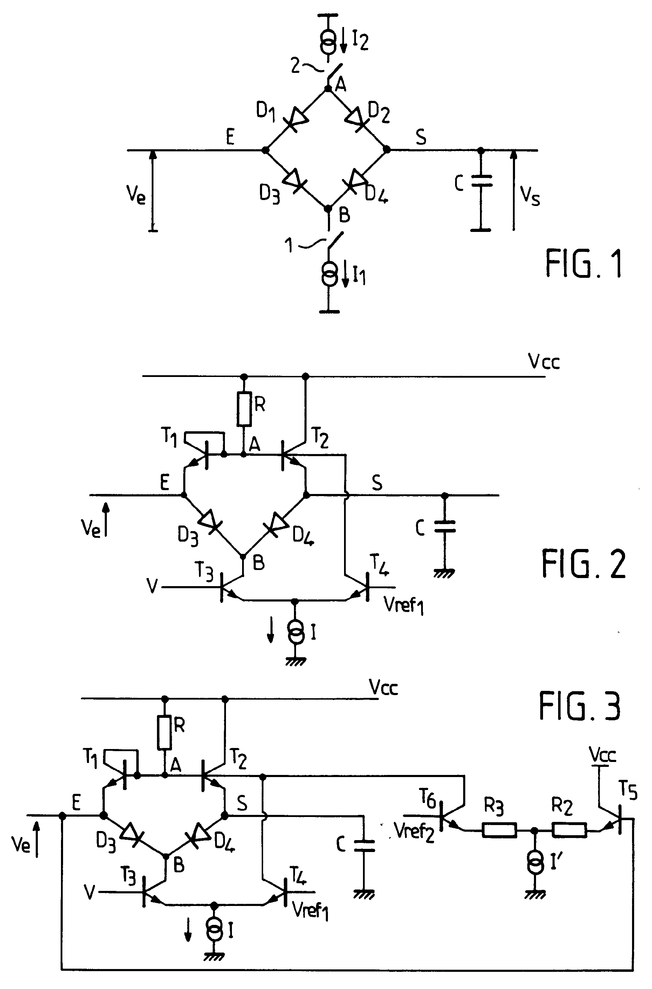

La figure 1 représente un schéma classique d'un échantillonneur-bloqueur. Il présente un pont de diodes à deux branches, l'une constituée par des diodes $D_1$ et $D_3$ disposées en direct et l'autre par des diodes $D_2$ et $D_4$ également disposées en direct. Le point A commun aux diodes $D_1$ et $D_2$ est relié à une source de courant $I_2$ à travers un dispositif de commutation 2. Le point B commun aux diodes $D_3$ et $D_4$ est relié à une source de courant $I_1$ à travers un dispositif de commutation 1. Le point commun aux diodes $D_1$ et $D_3$ constitue l'entrée E de l'échantillonneur qui reçoit un signal d'entrée $V_e$ à échantillonner. Le point commun aux diodes $D_2$ et $D_4$ constitue la sortie S de l'échantillonneur. Elle est connectée à un condensateur C qui mémorise une tension $V_s$.

En mode échantillonnage, les dispositifs de commutation 1 et 2 sont fermés. La tension $V_s$ copie la tension Ve aux bornes du condensateur C. On a $V_e = V_s$ quand le courant dans le condensateur C est nul, les diodes $D_1$ et $D_2$ étant identiques, ainsi que les diodes $D_3$ et $D_4$, et les sources de courant $I_1$ et $I_2$ délivrant un courant de même valeur.

En mode blocage, obtenu par ouverture simultanée des dispositifs de commutation 1 et 2, le pont présente

3

un état d'impédance élevée (infinie si les diodes sont supposées parfaites) et la tension Vs précédemment échantillonnée est mémorisée dans le condensateur C.

Ce type de montage présente un certain nombre d'inconvénients, à savoir :

- la nécessité d'appairer les sources de courant $I_1$ et $I_2$.
- la nécessité de commuter simultanément les sources de courant $I_1$ et $I_2$.
- l'obligation pratique d'utiliser une source de courant à base de transistors PNP (source $I_2$) ce qui contribue à limiter la vitesse de commutation dans le cas des procédés de fabrication usuels des circuits intégrés, pour lesquels les transistors PNP sont moins rapides que les transistors NPN.

Le circuit de la figure 2 propose une réalisation dans laquelle seule une source de courant commute, laquelle peut être à base de transistors NPN pour une meilleure rapidité dans le cas des procédés usuels.

Au lieu de la source de courant $I_2$ et du dispositif de commutation 2, est disposée une résistance R. La diode $D_1$ est réalisée sous la forme d'un transistor NPN $T_1$ dont la base et le collecteur sont court-circuités et dont l'émetteur est connecté à l'entrée E. La diode $D_2$ est remplacée par un transistor NPN $T_2$ dont l'émetteur est connecté à la sortie S et dont le trajet collecteur-base est en parallèle avec la résistance R. La diode $D_1$ pourrait être réalisée autrement mais ce mode de réalisation assure le mieux l'identité des caractéristiques avec la diode $D_2$. Enfin une source de courant I est agencée pour être commutée soit au point commun aux diodes $D_3$ et $D_4$ (point B) soit au point A commun aux bases des transistors $T_1$ et $T_2$.

Un transistor de type NPN $T_3$ a son collecteur connecté au point B et reçoit sur sa base un signal de commutation V. Un transistor $T_4$ de type NPN également a son collecteur connecté au point A, son émetteur connecté à celui du transistor $T_3$ et reçoit sur sa base une tension de référence $V_{ref1}$.

En mode échantillonnage ($V>V_{ref1}$) le transistor $T_3$ conduit et le transistor $T_4$ est bloqué. Le courant qui traverse la résistance R a pour valeur :

$$i = \frac{V_{cc} - V_{BET_1} - V_e}{R}$$

$V_{BET_1}$ désignant la tension base-émetteur du transistor $T_1$.

$V_{cc}$ tension d'alimentation.

Pour une recopie parfaite de la tension $V_e$, le courant traversant les quatre éléments du pont (transistor $T_1$, trajet collecteur-émetteur du transistor $T_2$, diodes $D_3$ et $D_4$) doivent être égaux à I/2. La résistance R doit donc être parcourue par un courant égal à I/2 (on néglige le courant de base du transistor $T_2$).

On a alors :

$$R = 2\frac{V_{cc} - V_{BET_1} - V_e}{I} \quad (1)$$

On notera que la présence du transistor $T_2$ permet une charge accélérée du condensateur C.

En mode bloqué ($V<V_{ref1}$), le transistor $T_4$ conduit et le transistor $T_3$ est bloqué. La résistance R est alors traversée par un courant égal à I. Ce courant produit dans la résistance R une chute de potentiel double de celle obtenue en mode échantillonnage, ce qui permet de bloquer les transistors $T_1$ et $T_2$. Aucun courant ne traverse non plus les diodes $D_3$ et $D_4$. Le pont est ainsi mis rapidement en état de haute impédance.

Le montage décrit ci-dessus présente une approximation en raison du fait (formule (1)) que les conditions de recopie ne sont pas indépendantes de la tension $V_e$ à recopier.

Le circuit de la figure 3 propose un circuit amélioré, lequel est pourvu d'un circuit de compensation venant s'ajouter aux autres éléments, par ailleurs non modifiés.

Le circuit de compensation comporte deux transistors $T_5$ et $T_6$ de type NPN dont les émetteurs sont éventuellement reliés par deux résistances de linéarisation $R_2$ et $R_3$ en série, au point commun desquelles est connectée une source de courant I'. La base du transistor $T_5$ est connectée à l'entrée E et son collecteur est référencé à la source de tension d'alimentation $V_{cc}$. La base de transistor $T_6$ reçoit une tension de référence $V_{ref2}$ et son collecteur est connecté au point A. La fonction de ce circuit de compensation est de prélever la partie excédentaire du courant qui traverse la résistance R de manière à maintenir dans le transistor $T_1$ un courant constant et égal à I/2 et à assurer ainsi l'égalité des courants dans les deux branches du pont quelle que soit la tension d'entrée $V_e$.

Soit $V_B$ la valeur de la tension minimale à échantillonner.

Soit $V_H$ la valeur de la tension maximale à échantillonner.

Soit $I_{6H}$ le courant traversant le transistor $T_6$ lorsque $V_e = V_H$

et $I_{6B}$ le courant traversant le transistor $T_6$ lorsque $V_e = V_B$.

On a alors :

$$\frac{V_{cc} - V_{BET_1} - V_H}{R} = \frac{I}{2} + I_{6H} \quad (2)$$

$$\frac{V_{cc} - V_{BET_1} - V_B}{R} = \frac{I}{2} + I_{6B} \quad (3)$$

D'où :

$$I_{6B} - I_{6H} = \frac{V_H - V_B}{R}$$

On peut choisir que tout le courant I' traverse le transistor $T_5$ lorsque $Ve = V_H$, soit $I_{6H} = 0$.
On a alors :

$$R = \frac{2(V_{cc} - V_{BET_1} - V_H)}{I}$$

On peut également choisir que tout le courant I' traverse le transistor $T_6$ lorsque $Ve = V_B$, soit $I_{6B} = I'$. Avec ces deux hypothèses cumulées, on obtient alors :

$$I' = \frac{V_H - V_B}{R}$$

Les résistances $R_2$ et $R_3$, d'égale valeur, ont pour fonction d'améliorer la linéarité. On peut calculer leur valeur aux points de fonctionnement où le courant I' se répartit dans un rapport 1/4, 3/4 entre les transistors $T_5$ et $T_6$.
C'est-à-dire

$$V_e = \frac{V_H + V_{ref_2}}{2} \text{ et } V_e = \frac{V_B + V_{ref_2}}{2}$$

Il suffit d'effectuer le calcul pour un des deux points de fonctionnement, en raison de la symétrie du montage.
Soit

$$V_e = \frac{V_H + V_{ref_2}}{2} = \frac{3V_H + V_L}{4}$$

Soit $I_{R2}$ le courant traversant la résistance $R_2$ et $I_{R3}$, celui traversant la résistance $R_3$.
La linéarité est assurée si, au point de fonctionnement précité :

$$I_{R2} = \frac{3}{4} I' \qquad I_{R3} = \frac{1}{4} I'$$

Il en résulte, en écrivant l'égalité des tensions au point commun aux résistances $R_2$ et $R_3$.

$$\frac{3V_H + V_B}{4} - V_{BET5} - \frac{3}{4} R_2 I' = \frac{V_H + V_B}{2} - V_{BET6} - R_2 I'$$

$V_{BET5}$ et $V_{BET6}$ désignant la tension base-émetteur des transistors $T_5$ et $T_6$.

$$\text{D'où } \frac{R_2 I'}{2} = \frac{V_H - V_B}{4} - (V_{BET5} - V_{BET6})$$

$$\text{soit } R_2 = R_3 = \frac{1}{I'} \left( \frac{V_H - V_B}{2} - \frac{2kT}{q} \text{Log3} \right)$$

$$\text{D'où } R_2 = R_3 = \frac{R}{2} - \frac{2kT}{q} \log 3 \times \frac{R}{V_H - V_B}$$

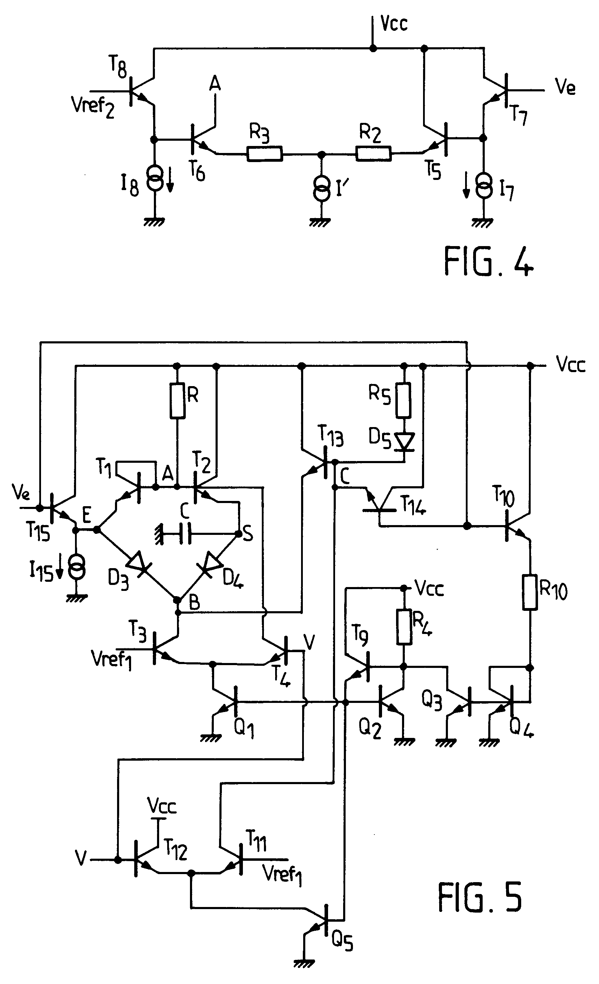

La dynamique admissible sur l'échantillonneur peut être augmentée en introduisant des diodes de décalage. La figure 4 montre un mode de réalisation dans lequel des transistors $T_7$ et $T_8$ montés en émetteur suiveur et présentant des sources de courant $I_7$ et $I_8$ connectées à leurs émetteurs respectifs. Ces transistors sont intercalés entre les bases des transistors $T_5$ et $T_6$ et leur sortie et délivrant leurs signaux d'entrée respectifs respectivement Ve et $V_{ref2}$.

Selon la figure 5, la source de courant I est réalisée de manière telle que l'équilibre des courants dans les deux branches et donc la qualité de la recopie ne dépend pas des variations éventuelles, notamment en fonction de la température, de la tension d'entrée ni de la valeur de la tension d'alimentation $V_{cc}$.

Cette fonction est réalisée en mettant en oeuvre des transistors $Q_1$ à $Q_4$, $T_9$ et $T_{10}$ pour obtenir la loi de variation désirée pour le courant I.

La tension d'entrée Ve est décalée d'une tension base-émetteur $V_{be}$ à l'aide d'un transistor $T_{15}$ présentant dans son émetteur une source de courant $I_{15}$.

Dans ces conditions, la formule (1) devient :

$$I = 2 \frac{V_{cc} - V_e}{R} \quad (4)$$

Le courant I est fourni par un transistor $Q_1$ dont le collecteur est connecté aux émetteurs couplés des transistors $T_3$ et $T_4$ et dont l'émetteur est relié au pôle de mode commun. Le transistor $Q_1$ forme un miroir de courant dans un rapport k avec un transistor $Q_2$. Le transistor $Q_2$ a sa base connectée à celle du transistor $Q_1$, son collecteur relié à la tension d'alimentation $V_{cc}$ à travers une résistance $R_4$ et son émetteur connecté au pôle de mode commun. Un transistor $T_9$ a son collecteur connecté à la tension d'alimentation $V_{cc}$, sa base au col-

lecteur du transistor $Q_2$ et son émetteur aux bases interconnectées des transistors $Q_1$ et $Q_2$. Le courant traversant le collecteur du transistor $Q_2$ dépend alors linéairement de la valeur de la résistance $R_4$ (et de la tension d'alimentation $V_{cc}$). Pour calculer le courant traversant la résistance $R_4$, on considère celle-ci en série avec deux diodes. Un transistor $Q_3$ a son collecteur connecté à celui du transistor $Q_2$, son émetteur au pôle de mode commun et a sa base connectée à celle du transistor $Q_4$ monté en diode par court-circuit base-collecteur avec lequel il forme un deuxième miroir de courant dans un rapport N. Un transistor $T_{10}$ reçoit sur sa base les signaux d'entrée $V_e$, a son collecteuur connecté à la source de tension d'alimentation $V_{cc}$ et son émetteur est relié à la base du transistor $Q_4$ à travers une résistance $R_{10}$.

Soit K le rapport entre les dimensions d'émetteur des transistors $Q_1$ et $Q_2$, et N le rapport entre les dimensions d'émetteur des transistors $Q_3$ et $Q_4$.

Soient $I_{Q1}$, $I_{Q2}$, $I_{Q3}$, $I_{Q4}$, et $I_{R4}$ les courants respectivement dans les collecteurs des transistors $Q_1$, $Q_2$, $Q_3$ et $Q_4$, et a travers la résistance $R_4$.

On a $I_{Q1} = I$

D'autre part :

$$I_{Q1} = k I_{Q2} = K (I_{R4} - I_{Q3}) = K (I_{R4} - N I_{Q4})$$

$$\text{On a } I_{R4} = \frac{V_{cc} - 2V_{BE}}{R_4}$$

$$I_{Q4} = \frac{V_e - 2V_{BE}}{R_{10}}$$

D'où

$$I_{Q1} = K \left( \frac{V_{cc} - 2V_{BE}}{R_4} - N \frac{Ve - 2V_{BE}}{R_{10}} \right)$$

$$I_{Q1} = K \frac{V_{cc}}{R_4} - \frac{KN}{R_{10}} V_e + 2KV_{BE} \left( \frac{N}{R_{10}} - \frac{1}{R_4} \right)$$

cette expression doit être identifiée à la formule (4). D'où :

$$\frac{2}{R} = \frac{K}{R_4} = \frac{KN}{R_{10}}$$

Soit $R_{10} = NR_4$ et $R_4 = \frac{KR}{2}$ donc $R_{10} = \frac{KNR}{2}$ Dans ces conditions, l'équilibre du pont est indépendant de la tension $V_e$, et de la tension d'alimentation $V_{cc}$, ce qui supprime donc également les dérivés thermiques de ces paramètres.

Le circuit représenté à la figure 5 comporte également des moyens destinés à améliorer le fonctionnement dynamique, en assurant la simultanéité du blocage du passage du courant dans les transistors $T_1$ et $T_2$ d'une part et les diodes $D_3$, $D_4$ d'autre part. Le blocage des transistors $T_1$ et $T_2$ intervient lorsque le transistor $T_4$ est traversé par le courant I/2. A ce moment là en effet, le potentiel au point A vaut $V_{cc} - V_e$ et tout le courant qui traverse la résistance R passe à travers le transistor $T_4$. Par contre, le courant collecteur du transistor $T_3$ continue transitoirement à traverser les diodes $D_3$ et $D_4$ jusqu'à ce que le transistor $T_3$ soit bloqué.

Le courant qui traverse la diode $D_4$ pendant cette situation transitoire est fourni par le condensateur C qui se décharge légèrement, ce qui introduit une légère erreur systématique sur la valeur de la tension mémorisée.

Un transistor $T_{13}$ dont le collecteur est connecté à la source de tension d'alimentation $V_{cc}$ et son émetteur au point B (point commun à la cathode des diodes $D_3$ et $D_4$ et au collecteur du transistor $T_3$) a pour fonction de fournir au collecteur du transistor $T_3$ ledit courant transitoire manière à assurer ledit blocage simultané et d'éviter ladite décharge transitoire du condensateur C. Pour ce faire, sa base est connectée à une borne d'une branche série comportant une résistance $R_5$ et une diode $D_5$, l'autre borne de la branche étant connectée à la source de tension d'alimentation $V_{cc}$. Un transistor $T_{15}$ dont l'émetteur est connecté à l'entrée E du pont décale d'une $V_{BE}$ le niveau de signal d'entrée Ve. Une source de courant $I_{15}$ force un courant constant dans son émetteur. Les diodes $D_3$ et $D_4$ sont des diodes Schottky. La base du transistor $T_{13}$ est connectée au collecteur d'un transistor $T_{11}$ dont l'émetteur est couplé à celui d'un transistor $T_{12}$ dont le collecteur est porté au potentiel d'alimentation $V_{cc}$. Les bases des transistors $T_{11}$ et $T_{12}$ reçoivent les tensions respectivement $V_{ref1}$ et V c'est-à-dire que son fonctionnement est simultané avec celui de la paire $T_3$, $T_4$. Une source de courant (transistor $Q_5$) est connectée aux émetteurs des transistors $T_{11}$ et $T_{12}$. La base du transistor $Q_5$ est connectée à celle du transistor $Q_2$, ce qui fait que ces deux transistors ont leur collecteur traversé par des courants identiques s'ils ont la même dimension. Lorsque le pont est conducteur, $V_e$ est au niveau bas, le transistor $T_{11}$ conduit et le transistor $T_{13}$ est bloqué. Lors du blocage du pont, le transistor $T_{13}$ est mis en conduction de manière à fournir le courant transitoire dont a besoin le col lecteur du transistor $T_3$.

Les conditions de fonctionnement sont alors les suivantes :

- lorsque le pont est conducteur, la base du transistor $T_{13}$ (point C) doit être à $V_e - V_{BE}$. Sa tension base-émetteur vaut alors en effet $V_{DS}$, tension d'une diode Schottky en direct (0,5V) et le transistor $T_{13}$ est bloqué. Si $Q_2$ et $Q_5$ ont les mêmes dimensions, on a $I_{Q2} = I_{Q5}$, $I_{Q5}$ désignant le courant collecteur de $Q_5$. D'où :

$$I_{Q5} = \frac{1}{K} \frac{2(V_{cc} - V_e)}{R} = \frac{R}{R_4} \frac{V_{cc} - V_e}{R} = \frac{V_{cc} - V_e}{R_4}$$

Le potentiel à la base du transistor $T_{13}$ vaut alors :

$$V_{cc} - \frac{R_5}{R_4}(V_{cc} - V_e) - V_{BE} \leqq V_e - V_{BE}$$

d'où $R_5 \geqq R_4$

Lors du blocage du pont, la tension V augmente, mettant en conduction le transistor $T_{12}$ et bloquant le transistor $T_{11}$.

Le potentiel de la base du transistor $T_{13}$ augmente, et celui-ci peut alors fournir le courant transistoire au transistor $T_3$.

Les diodes $D_3$ et $D_4$ étant des diodes Schottky (tension $V_{DS}$ en direct $\sim$ 0,5V), l'excursion de tension sur le collecteur du transistor $T_{11}$ est égale à $(V_{BE} - V_{DS}) \simeq 0,3V$ pour mettre en conduction le transistor $T_{13}$.

Cette faible excursion permet une réponse très rapide.

Il est possible d'améliorer la sécurité du blocage du transistor $T_{13}$ lorsque le pont est alimenté en choisissant $R_5 > R_4$ et en ajoutant un transistor $T_{14}$ dont la base reçoit la tension d'entrée Ve, dont le collecteur est connecté à la source de tension d'alimentation $V_{cc}$ et dont l'émetteur est connecté au point C.

L'invention ne se limite pas aux modes de réalisation décrits et représentés. En particulier, les diodes $D_3$ et $D_4$ ne sont pas nécessairement des diodes Schottky au cas où le montage de correction dynamique met en oeuvre le transistor $T_{13}$. Il suffit en effet que par exemple le rapport des dimensions entre le transistor $T_{13}$ et les diodes $D_3$ et $D_4$ réalisées dans cette hypothèse à partir de transistors bipolaires soit tel qu'un courant négligeable parcoure le transistor $T_{13}$ lorsque le pont est conducteur.

On remarquera en outre que toutes les fonctions, et en particulier l'amélioration du fonctionnement dynamique sont réalisables à partir de transistors du même type, de préférence NPN, ce qui permet d'éviter les disparités dues aux différences de propriétés notamment en régime transitoire, de transistors de type différents.

En particulier, l'amélioration du fonctionnement dynamique est réalisable avec des transistors du même type que ceux mis en oeuvre pour la commutation de la première source de courant commutable (en particulier la deuxième source de courant et le premier étage différentiel.

## Revendications

1. Circuit de commutation comportant un pont de diodes présentant une première branche série comportant une première ($T_1$) et une deuxième ($D_3$) diode en direct, en parallèle avec une deuxième branche série comportant une troisième ($T_2$) et une quatrième ($D_4$) diode en direct, une première extrémité (B) commune aux deux dites branches série étant connectée à une première source de courant commutable présentant un premier état où elle est couplée à la première extrémité commune et un deuxième état où elle est découplée de la première extrémité commune, une deuxième extrémité (A) comme aux deux dites branches étant le point commun auxdites première ($T_1$) et troisième ($T_2$) diodes, la première source de courant commutable étant agencée pour être couplée à la deuxième extrémité commune (A) dans l'état de blocage la première branche série comportant une borne d'entrée (E) au point commun à la première ($T_1$) et à la deuxième ($D_3$) diode et agencée pour recevoir une tension d'entrée, la deuxième branche série comportant une borne de sortie (S) au point commun à la troisième ($T_2$) et à la quatrième ($D_4$) diode, caractérisé en ce que la troisième diode est constituée par le trajet base-émetteur d'un premier transistor ($T_2$) dont le collecteur est relié à une source de tension d'alimentation, et en ce qu'il comporte une première résistance (R) disposée entre ladite deuxième extrémité commune (A) et ladite source de tension d'alimentation ($V_{cc}$).

2. Circuit selon la revendication 1 caractérisé en ce que la première source de courant commutable comporte un premier étage différentiel ($T_3, T_4$) agencé pour commuter un courant (I) d'intensité donnée entre lesdites première et deuxième extrémité commune respectivement dans l'état d'échantillonnage et l'état de blocage, en réponse à un signal de commande (V).

3. Circuit selon la revendication 2 caractérisé en ce qu'il comporte un circuit générateur de courant ($T_5, T_6, R_2, R_3$) agencé pour injecter à ladite deuxième extrémité commune (A) un courant de compensation variant en fonction de la tension d'entrée de manière à rendre l'équilibre du pont indépendant de ladite tension d'entrée.

**4.** Circuit selon la revendication 3 caractérisé en ce que le générateur de courant est un deuxième étage différentiel commutable agencé pour que ledit courant de compensation soit produit à partir d'une troisième source de courant d'intensité donnée (I').

**5.** Circuit selon la revendication 4 caractérisé en ce que le deuxième étage différentiel présente un troisième ($T_5$) et un quatrième ($T_6$) transistor dont les émetteurs sont couplés à travers une deuxième ($R_2$) et une troisième ($R_3$) résistance en série au point commun desquelles est connectée la troisième source de courant, la base du troisième transistor ($T_5$) étant agencée pour recevoir ladite tension d'entrée et son collecteur étant connecté à la source de tension d'alimentation, la base du quatrième transistor ($T_6$) étant agencée pour recevoir une tension de référence et son collecteur étant connecté à ladite deuxième extrémité commune (A).

**6.** Circuit selon la revendication 5, caractérisé en ce que les trajet base-émetteur des troisième ($T_5$) et quatrième ($T_6$) transistors sont en série avec respectivement une cinquième ($T_7$) et une sixième ($T_8$) diode de décalage de niveau.

**7.** Circuit selon une des revendications 4 à 6 caractérisé en ce que la troisième source de courant a pour intensité :

$$I' = \frac{V_H - V_B}{R} \text{ avec } R = \frac{2}{I} (V_{cc} - V_{BE} - V_H)$$

$V_H$ :      valeur maximale du signal d'entrée $V_e$
$V_B$ :      valeur minimale du signal d'entrée $V_e$
$R$ :      valeur de la première résistance.
$V_{BE}$ :      tension base-émetteur d'un transistor.
$V_{cc}$ :      tension d'alimentation.
$I$ :      intensité de la première source de courant d'intensité donnée.

**8.** Circuit selon la revendication 7 caractérisé en ce que les deuxième, $R_2$, et troisième, $R_3$, résistances ont la même valeur, égale à :

$$R_2 = R_3 = \frac{R}{2} - \frac{2kT}{q} \frac{R}{V_H - V_B} Log3$$

**9.** Circuit selon la revendication 2 caractérisé en ce que la première source de courant est agencée de manière que son courant I varie selon une loi donnée, à savoir :

$$I = 2 \frac{V_{cc} - V_e}{R}$$

$R$ :      valeur de la première résistance.
$V_{cc}$ :      tension d'alimentation.
$V_e$ :      tension d'entrée.

**10.** Circuit selon la revendication 9 caractérisé en ce que la première source de courant est montée en miroir de courant dans un rapport K avec une quatrième source de courant ($Q_2, R_4$) dont l'intensité est fonction de la tension d'alimentation, et qui fournit une partie de son courant à une cinquième source de courant ($Q_3, Q_4, T_{10}, R_{10}$) dont l'intensité est fonction de la tension d'entrée, de manière que l'intensité de la première source de courant suive la loi précitée.

**11.** Circuit selon la revendication 10 caractérisé en ce que la quatrième source de courant comporte une quatrième résistance ($R_4$) dont une première borne est connectée à la source de tension d'alimentation et dont la deuxième borne est connectée à la cinquième source de courant ($Q_3$), la quatrième résistance ($R_4$) étant agencée de manière telle que le courant de la quatrième source de courant dépende linéairement de la valeur de la quatrième résistance ($R_4$).

**12.** Circuit selon la revendication 11 caractérisé en ce que le rapport K entre les courants des première et quatrième source de courant a pour valeur

$$K = 2 \frac{R_4}{R}$$

avec $R_4$ = valeur de la quatrième résistance.

13. Circuit selon une des revendications 10 à 12 caractérisé en ce que la cinquième source de courant comporte d'une part un cinquième transistor ($T_{10}$) dont la base est agencée pour être alimentée par ladite tension d'entrée ($V_e$), dont le collecteur est connecté à ladite source de tension d'alimentation et dont l'émetteur comporte en série une cinquième résistance ($R_{10}$) et une septième diode en direct ($Q_4$) et d'autre part un sixième transistor ($Q_3$), dont le collecteur est connecté à la deuxième borne de la quatrième résistance ($R_4$) pour délivrer le courant désiré, le point commun à la cinquième résistance ($R_{10}$) et à la septième diode ($Q_4$) étant connecté à la base du sixième transistor ($Q_3$).

14. Circuit selon la revendication 13 caractérisé en ce que les dimensions du sixième transistor ($Q_3$) et de la septième diode ($Q_4$) sont telles qu'ils sont traversés par des courants dans un rapport N et en ce que :
$$N = \frac{R_{10}}{R_4}$$
$R_{10}$ désignant la valeur de la cinquième résistance.

15. Circuit selon une des revendications 1 à 14 caractérisé en ce qu'il comporte un deuxième circuit générateur de courant agencé pour injecter un courant transitoire à ladite première extrémité commune (B) lors d'une transition de l'état d'échantillonnage à l'état de blocage.

16. Circuit selon la revendication 15 caractérisé en ce que le deuxième circuit générateur de courant comporte un septième transistor ($T_{13}$) dont le collecteur est connecté à la source de tension d'alimentation, dont l'émetteur est connecté à la première extrémité commune (B) et dont la base est reliée d'une part à la source de tension d'alimentation à travers une huitième diode ($D_5$) en série avec une sixième résistance ($R_5$) et d'autre part à une borne de sortie d'un troisième circuit de commutation agencé pour le connecter à une sixième source de courant ($Q_5$) dont l'intensité est proportionnelle à celle de la quatrième source de courant ($Q_2$), lors du passage de l'état d'échantillonnage à l'état de blocage.

17. Circuit selon la revendication 16 caractérosé en ce que les deuxième ($D_3$) et quatrième ($D_4$) diodes sont des diodes Schottky.

18. Circuit selon une des revendications 16 ou 17 caractérisé en ce que la quatrième et la sixième source de courant ont la même intensité et en ce que :
$$R_5 \cong R_4$$
$R_5$ désignant la valeur de la sixième résistance.

19. Circuit selon une des revendications 15 à 18 caractérisé en ce que la première source de courant commutable et le deuxième circuit générateur de courant comportent des éléments semiconducteurs du même type (NPN).

20. Circuit échantillonneur-bloqueur caractérisé en ce qu'il comporte un circuit de commutation selon une quelconque des revendications précédentes et un condensateur de mémorisation (C) connecté à ladite borne de sortie, le premier état étant un état-d'échantillonnage, et le deuxième état étant un état de blocage.

**Patentansprüche**

1. Schaltkreis mit einer Diodenbrücke, die eine erste Reihenschaltung aufweist mit einer ersten ($T_1$) und einer zweiten ($D_3$) Diode, die zu einer zweiten Reihenschaltung mit einer dritten ($T_2$) und einer vierten Diode ($T_2$) parallelgeschaltet sind, wobei ein erstes gemeinsames Ende (B) der obengenannten zwei Reihenschaltungen mit einer ersten schaltbaren Stromquelle verbunden ist, die einen ersten Zustand darstellt, in dem er mit dem ersten gemeinsamen Ende gekoppelt ist und einen zweiten Zustand, in dem er von dem ersten gemeinsamen Ende entkoppelt ist, wobei ein zweites gemeinsames Ende (A) der zwei genannten Zweige der gemeinsame Punkt der genannten ersten ($T_1$) und dritten Diode ($T_2$) ist, wobei die erste schaltbare Stromquelle dazu bestimmt ist mit dem zweiten gemeinsamen Ende (A) in dem Sperrzustand gekoppelt zu werden, wobei die erste Reihenschaltung eine Eingangsklemme (E) am gemeinsamen Verbindungspunkt der ersten ($T_1$) und der zwieten Diode ($D_3$) aufweist und dazu eingerichtet ist, eine Eingangsspannung zu empfangen, wobei die zweite Reihenschaltung eine Ausgangsklemme (5) aufweist am Verbindungspunkt der dritten ($T_2$) und der vierten Diode ($D_4$), <u>dadurch gekennzeichnet</u>, daß die dritte Diode durch die Basis-Emitter-Strecke eines ersten Transistors ($T_2$) gebildet ist, dessen Kollektor mit einer Speisespannungsquelle verbunden ist und daß der Schaltkreis einen ersten Widerstand (R) aufweist zwischen dem genannten zweiten gemeinsamen Ende (A) und der genannten Speisespannungsquelle ($V_{cc}$), wobei die zweite schaltbare Stromquelle dazu vorgesehen ist, mit dem zweiten gemeinsamen Ende (A) in zum Sperrzustand gekoppelt zu werden.

2. Schaltkreis nach Anspruch 1, <u>dadurch gekennzeichnet</u>, daß die erste schaltbare Stromquelle eine erste differentielle Stufe ($T_3$, $T_4$) aufweist zum Schalten des Stromes (I) einer bestimmten Stärke zwischen dem genannten ersten und zweiten gemeinsamen Ende in dem Abtastzustand und in dem Sperrzustand, in Antwort auf ein Steuersignal (V).

3. Schaltkreis nach Anspruch 2, <u>dadurch gekennzeichnet</u>, daß er einen Stromgeneratorkreis ($T_5$, $T_6$, $R_2$, $R_3$) aufweist zum Injektieren an dem genannten zweiten gemeinsamen Ende (A) eines Ausgleichstromes, variierend in Funktion der Eingangsspannung, damit ein Gleichgewicht der Brücke beibehalten wird, unabhängig von der genannten Eingangsspannung.

4. Schaltkreis nach Anspruch 3, <u>dadurch gekennzeichnet</u>, daß der Stromgenerator eine zweite schaltbare differentielle Stufe ist, damit der genannte Ausgleichstrom von einer dritten Stromquelle erzeugt wird mit einer bestimmten Stärke ($I'$).

5. Schaltkreis nach Anspruch 4, <u>dadurch gekennzeichnet</u>, daß die zweite differentuelle Stufe einen dritten ($T_5$) und einen vierten Transistor ($T_6$) aufweist, deren Emitter über einen zweiten ($R_2$) und einen dritten Widerstand ($R_3$) in Reihe geschaltet sind, mit deren gemeinsamem Punkt die dritte Stromquelle verbunden ist, wobei die Basis des dritten Transistors ($T_5$) dazu vorgesehen ist, die genannten Eingangsspannung zu erhalten und der Kollektor mit der Speisespannungsquelle verbunden ist, wobei die Basis des vierten Transistors ($T_6$) dazu vorgesehen ist, eine Bezugsspannung zu erhalten und der Kollektor mit dem gemeinsamen zweiten Ende (A) verbunden ist.

6. Schaltkrteis nach Anspruch 5, <u>dadurch gekennzeichnet</u>, daß die Basis-Emitterstrecke des dritten ($T_5$) und des vierten ($T_6$) Transistors mit einer fünften ($T_7$) und einer sechsten Pgelabtastdiode ($T_8$) in Reihe geschaltet sind.

7. Schaltkreis nach Anspruch 4 bis 6, <u>dadurch gekennzeichnet</u>, daß die dritte Stromquelle die nachfolgende Stärke hat:

$$I' = \frac{V_H - V_B}{R}$$

mit

$$R = \frac{2}{I}(V_{CC} - V_{BE} - V_H)$$

$V_H$ :      maximaler Wert des Eingangssignals $V_e$
$V_B$ :      minimaler Wert des Eingangssignals $V_e$
R :      Wert des ersten Transistors
$V_{BE}$ :      Basis-Emitter-Spannung eines Transistors
$V_{CC}$ :      Speisespannung
I :      Stärke der ersten Stromquelle mit einem bestimmten Wert.

8. Schaltkreis nach Anspruch 7, <u>dadurch gekennzeichnet</u>, daß der zweite ($R_2$) und der dritte Widerstand ($R_3$) denselben Wert haben, gleich:

$$R_2 = R_3 = \frac{R}{2} - \frac{2kt}{q} \frac{R}{V_H - V_B} Log3$$

9. Schaltkreis nach Anspruch 2, <u>dadurch gekennzeichnet</u>, daß die erste Stromquelle derart vorgesehen ist, daß der Strom I nach einem bestimmten Gesetz variiert, und zwar:

$$I = \frac{V_{cc} - V_e}{R}$$

wobei R der Wert des ersten Widerstandes ist,
$V_{cc}$ die Speisespannung ist und
$V_e$ die Eingangsspannung ist.

**10.** Schaltkreis nach Anspruch 9, dadurch gekennzeichnet, daß die erste Stromquelle in Stromspiegelschaltung vorgesehen ist in einem verhältnis K mit einer vierten Stromquelle ($Q_2$, $Q_4$), deren Stärke eine Funktion der Speisespannung ist, und die einen Teil des Stromes zu einer fünften Stromquelle ($Q_3$, $Q_4$, $T_{10}$, $R_{10}$) führt, deren Stärke eine Funktion der Eingangsspannung ist, derart, daß die Stärke der ersten Stromquelle dem genannten Gesetz folgt.

**11.** Schaltkreis nach Anspruch 10, dadurch gekennzeichnet, daß die vierte Stromquelle einen vierten Widerstand ($R_4$) aufweist, dessen einer Anschluß mit der Speisespannungsquelle verbunden ist und dessen zweiter Anschluß mit der fünften Stromquelle ($Q_3$) verbunden ist, wobei der vierte Widerstand ($R_4$) derart vorgesehen ist, daß der Strom der vierten Stromquelle linear von dem Wert des vierten Widerstandes ($R_4$) abhängig ist.

**12.** Schaltkreis nach Anspruch 11, dadurch gekennzeichnet, daß das verhältnis K zwischen der ersten und der vierten Stromquelle den nachfolgenden Wert hat:

$$K = 2\frac{R_4}{R}$$

mit $R_4$ = den Wert des vierten Widerstandes.

**13.** Schaltkreis nach einem der Ansprüche 10 bis 12, dadurch gekennzeichnet, daß die fünfte Stromquelle einerseits einen fünften Transistor ($T_{10}$) aufweist, dessen Basis vorgesehen ist zum Zuführen der genannten Eingangsspannung ($V_e$), dessen Kollektor mit der genannten Speisespannungsquelle verbunden ist und dessen Emitter in Reihe mit einem fünften Widerstand ($R_{10}$) und einer siebenten Gleichstromdiode ($Q_4$) und ebenfalls mit einem sechsten Transistor ($Q_3$) verbunden ist, dessen Kollektor mit dem zweiten Anschluß des vierten Widerstandes ($R_4$) verbunden ist zum Liefern des gewünschten Stromes, wobei der Verbindungspunkt des fünften Widerstandes ($R_{10}$) und der siebenten Diode ($Q_4$) mit der Basis des sechsten Transistors ($Q_3$) verbunden ist.

**14.** Schaltkreis nach Anspruch 13, dadurch gekennzeichnet, daß die Abmessungen des sechsten Transistors und der siebenten Diode sind vorzugsweise derart, daß sie von Strömen durchlaufen werden mit einer Rate N, und daß:

$$N = \frac{R_{10}}{R_4}$$

wobei $R_{10}$ den Wert des fünften Widerstandes bezeichnet.

**15.** Schaltkreis nach Anspruch 14, dadurch gekennzeichnet, daß er einen zweiten Stromgenerator aufweist zum Eingeben eines Übergangsstromes zu dem genannten gemeinsamen Ende (B) während der Änderung aus dem Abtastzustand in den Haltezustand, zum Erzeugen des Übergangsstroms durch die erste differentielle Stufe.

**16.** Schaltkreis nach Anspruch 15, dadurch gekennzeichnet, daß der zweite Stromgenerator einen siebenten Transistor ($T_{13}$) aufweist, dessen Kollektor mit der Speisespannungsquelle verbunden ist, dessen Emitter mit dem ersten gemeinsamen Ende (B) verbunden ist und dessen Basis mit der Speisespannungsquelle verbunden ist über eine achte Diode ($D_5$), die in Reihe mit einem sechsten Widerstand ($R_5$) und ebenfalls mit einer Ausgangsklemme eines dritten Schaltkreises verbunden ist, der vorgesehen ist zum Verbinden desselben mit einer sechsten Stromquelle ($Q_5$), deren Stärke zu der der vierten Stromquelle ($Q_2$) proportional ist, wenn die Änderung aus dem ersten in den zweiten Zustand durchgeführt wird.

**17.** Schaltkreis nach Anspruch 16, dadurch gekennzeichnet, daß die zweite ($D_3$) und die vierte Diode ($D_4$) Schottky-Dioden sind.

**18.** Schaltkreis nach Anspruch 16 oder 17, dadurch gekennzeichnet, daß die vierte und die sechste Stromquelle dieselbe Stärke haben und zwar:

$$R_5 \cong R_4$$

wobei $R_5$ den Wert des sechsten Widerstandes darstellt.

**19.** Schaltkreis nach Anspruch 15 bis 18, dadurch gekennzeichnet, daß die erste schaltbare Stromquelle und der zweite Stromerzeugerkreis Halbleiterelemente gleich Typs (NPN) aufweisen.

**20.** Abtast-und-Halteschaltung, dadurch gekennzeichnet, daß sie einen Schaltkreis nach einem der vorstehenden Ansprüche aufweist und einen Speicherkondensator (C), der mit der genannten Ausgangsklemme verbunden ist, wobei der erste Zustand ein Abtastzustand ist und der zweite Zustand ein Sperrzustand ist.

**Claims**

1. A switching circuit, particularly for a sample-and-hold circuit, comprising a diode bridge having a first series branch comprising a first ($T_1$) and a second ($D_3$) diode poled in the forward direction, which branch is arranged in parallel with a second series branch comprising a third ($T_2$) and a fourth ($D_4$) diode poled in the forward direction, a first end (B) common to said two series branches being connected to a first switchable current source having a first state, in which it is coupled to the first common end, and a second state, in which it is decoupled from the first common end, a second end (A) common to said two branches (A) being the node common to said first ($T_1$) and said third ($T_2$) diode, the first switchable current source being arranged to be coupled to the second common end (A) in the holding state, the first series branch having an input terminal (E) at the node common to the first ($T_1$) and the second ($D_3$) diode and being arranged to receive an input voltage, the second series branch having an output terminal (S) at the node common to the third ($T_2$) and the fourth diode ($D_4$), characterised in that the third diode is constituted by the base-emitter path of a first transistor ($T_2$) whose collector is coupled to a supply voltage source, and in that it comprises a first resistor (R) arranged between said second common end (A) and said supply voltage source ($V_{cc}$).

2. A circuit as claimed in Claim 1, characterised in that the first switchable current source comprises a first differential stage ($T_3$, $T_4$) adapted to switch a current (I) of given value between said first and said second common end in the sampling state and in the holding state, respectively, in response to a control signal (V).

3. A circuit as claimed in Claim 2, characterised in that it comprises a current generator ($T_5$, $T_6$, $R_2$, $R_3$) adapted to inject at the second common end (A) a compensation current which varies as a function of the input voltage so as to make the balance of the bridge independent of said input voltage.

4. A circuit as claimed in Claim 3, characterised in that the current generator is a second switchable differential stage arranged in a manner such that said compensation current is derived from a third current source of given current value (I').

5. A circuit as claimed in Claim 4, characterised in that the second differential stage comprises a third ($T_5$) and a fourth ($T_6$) transistor whose emitters are coupled *via* a second ($R_2$) and a third ($R_3$) resistor in series, the node between said resistors being connected to the third current source, the base of the third transistor ($T_5$) being arranged to receive said input voltage and its collector being connected to the supply voltage source, the base of the fourth transistor ($T_6$) being arranged to receive a reference voltage and its collector being connected to said second common end (A).

6. A circuit as claimed in Claim 5, characterised in that the base-emitter paths of the third ($T_5$) and the fourth ($T_6$) transistor are connected in series with a fifth ($T_7$) and a sixth ($T_8$) level shifting diode.

7. A circuit as claimed in any one of the Claims 4 to 6, characterised in that third current source has the following current value:

$$I' = \frac{V_H - V_B}{R} \text{ with } R = \frac{2}{I}(V_{cc} - V_{BE} - V_H)$$

$V_H$ :     maximum value of the input signal $V_e$
$V_B$ :     minimum value of the input signal $V_e$
R :     value of the first resistor
$V_{BE}$ :     base-emitter voltage of a transistor
$V_{cc}$ :     supply voltage
I :     current value of the first current source of given current value.

8. A circuit as claimed in Claim 7, characterised in that the second ($R_2$) and third ($R_3$) resistors have the same value, equal to:

$$R_2 = R_3 = \frac{R}{2} - \frac{2kT}{q}\frac{R}{V_H - V_B}\text{Log3}$$

9. A circuit as claimed in Claim 2, characterised in that the first current source is adapted so as to supply a current I which varies according to a given law, *i.e.*:

$$I = 2\frac{V_{cc} - V_e}{R}$$

R : value of the first resistor
$V_{cc}$ : supply voltage
$V_e$ : input voltage.

10. A circuit as claimed in Claim 9, characterised in that the first current source is arranged as a current mirror circuit having a proportion K to a fourth current source ($Q_2$, $R_4$) whose current value is a function of the supply voltage and which supplies a part of its current to a fifth current source ($Q_3$, $Q_4$, $T_{10}$, $R_{10}$) whose current value is a function of the input voltage, in such a manner that the current value of the first current source obeys said law.

11. A circuit as claimed in Claim 10, characterised in that the fourth current source comprises a fourth resistor ($R_4$) having a first terminal connected to the supply voltage source and having a second terminal connected to the fifth current source ($Q_3$), the fourth resistor ($R_4$) being arranged in such a manner that the current of the fourth current source depends linearly on the value of the fourth resistor ($R_4$).

12. A circuit as claimed in Claim 11, characterised in that the ratio K between the currents of the first and the fourth current source has a value

$$K = 2\frac{R_4}{R}$$

where $R_4$ = value of the fourth resistor.

13. A circuit as claimed in any one of the Claims 10 to 12, characterised in that the fifth current source comprises a fifth transistor ($T_{10}$) whose base is arranged to receive said input voltage ($V_e$), whose collector is connected to said supply voltage source and whose emitter is arranged in series with a fifth resistor ($R_{10}$) and a seventh diode ($Q_4$) poled in the forward direction, and a sixth transistor ($Q_3$) whose collector is connected to the second terminal of the fourth resistor ($R_4$) to supply the desired current, the node between the fifth resistor ($R_{10}$) and the seventh diode ($Q_4$) being connected to the base of the sixth transistor ($Q_3$).

14. A circuit as claimed in Claim 13, characterised in that the dimensions of the sixth transistor ($Q_3$) and the seventh diode ($Q_4$) are such that the currents flowing in them are in a ratio of N and in that:

$$N = \frac{R_{10}}{R_4}$$

$R_{10}$ being the value of the fifth resistor.

15. A circuit as claimed in any one of the Claims 1 to 14, characterised in that it comprises a second current generator circuit adapted to inject a transient current at said first common end (B) during a change from the sampling state to the holding state.

16. A circuit as claimed in Claim 15, characterised in that the second current generator circuit comprises a seventh transistor ($T_{13}$) whose collector is connected to the supply voltage source, whose emitter is connected to the first common end (B) and whose base is coupled to the supply voltage source via an eighth diode ($D_5$) in series with a sixth resistor ($R_5$) and to an output terminal of a third switching circuit adapted to connect it to a sixth current source ($Q_5$), whose current value is proportional to that of the fourth current source ($Q_2$), during the change from the sampling state to the holding state.

17. A circuit as claimed in Claim 16, characterised in that the second ($D_3$) and the fourth ($D_4$) diode are Schottky diodes.

18. A circuit as claimed in Claim 16 or 17, characterised in that the fourth and the sixth current source have the same current value and in that:

$$R_5 \cong R_4$$

$R_5$ being the value of the sixth resistor.

19. A circuit as claimed in any one of the Claims 15 to 18, characterised in that the first switchable current source and the second current generator circuit comprise semiconductor elements of the same type (NPN).

20. A sample-and-hold circuit, characterised in that it comprises a switching circuit as claimed in any one of the preceding Claims and a holding capacitor (C) connected to said output terminal, the first state being a sampling state the second state being a holding state.

FIG. 1

FIG. 2

FIG. 3

15

FIG. 4

FIG. 5